(19) Europäisches Patentamt
European Patent Office
Office européen des brevets

(11) **EP 1 072 896 B1**

(12) **EUROPÄISCHE PATENTSCHRIFT**

(45) Veröffentlichungstag und Bekanntmachung des Hinweises auf die Patenterteilung:
**17.06.2009   Patentblatt 2009/25**

(51) Int Cl.:
*G01R 27/08* (2006.01)          *G01R 17/02* (2006.01)
*G01R 27/14* (2006.01)          *G01K 7/20* (2006.01)

(21) Anmeldenummer: **00115453.3**

(22) Anmeldetag: **18.07.2000**

(54) **Schaltungsanordnung zur Messung eines veränderlichen Widerstandes**

Circuit for measuring a variable resistance

Circuit pour mesurer une résistance variable

(84) Benannte Vertragsstaaten:
**AT BE CH CY DE DK ES FI FR GB GR IE IT LI LU MC NL PT SE**

(30) Priorität: **23.07.1999   DE 19934644**

(43) Veröffentlichungstag der Anmeldung:
**31.01.2001   Patentblatt 2001/05**

(73) Patentinhaber: **Honeywell Technologies Sarl 1110 Morges (CH)**

(72) Erfinder: **Ebert, Volker**
**70771 Leinfelden (DE)**

(74) Vertreter: **TBK-Patent**
**Bavariaring 4-6**
**80336 München (DE)**

(56) Entgegenhaltungen:
**DE-A- 2 649 609          DE-A- 3 735 900**
**DE-C- 19 641 648          GB-A- 2 267 967**
**US-A- 4 536 851**

**Beschreibung**

Die vorliegende Erfindung bezieht sich auf eine Schaltungsanordnung zur Messung eines veränderlichen Widerstandes nach dem Gattungsbegriff des Patentanspruches 1.

Derartige Schaltungsanordnungen sind vielfach bekannt. So zeigt z. B. die DE-C-37 35 900 eine Schaltungsanordnung, bei der ein zu bestimmender Widerstand über die Messung des Spannungsabfalles in an sich bekannter Weise ermittelt, aber unterschiedliche Massepotentiale berücksichtigt werden.

Regler als externe Schaltungen werden oftmals an Temperaturfühler angeschlossen, um z.B. dem Regler einen Temperatur-Istwert vorzugeben. Da der Regler die Größe seiner inneren Spannungsquelle und seinen Längswiderstand kennt, bereitet es ihm keine Schwierigkeiten, die Größe des veränderlichen Widerstandes zu bestimmen. Wenn aber z.B. der Temperaturfühler mit einer Temperaturanzeige versehen ist, so kann nicht einfach in dem Temperaturfühler ein dem Spannungsabfall über dem veränderlichen Widerstand entsprechender Wert angezeigt werden, da die interne Schaltung des Temperaturfühlers die durch den Regler angelegte Spannung nicht kennt. Insbesondere werden derartige Temperaturfühler an verschiedene Regler angelegt, die dem Temperaturfühler unterschiedliche Spannungen zur Verfügung stellen, so daß der Spannungsabfall über dem veränderlichen Widerstand keine zuverlässige Aussage über die Temperatur liefert. Abhilfe könnte dadurch geschaffen werden, daß man z.B. sowohl den Strom als auch die Spannung über dem veränderlichen Widerstand mißt. Auch könnte man zwei veränderliche Widerstände vorsehen, wobei einer z.B. von dem Regler und einer von einer gesonderten bekannten Spannungsquelle im Temperaturfühler angesteuert wird.

Die vorliegende Erfindung löst die Aufgabe, den veränderlichen einzigen Widerstand sowohl durch die externe Schaltung (Regler) als auch durch die interne Schaltung (Temperaturfühler) mit geringem Schaltungsaufwand zu messen, ohne daß die eine Messung die andere Messung merklich beeinflußt.

Die Lösung dieser Aufgabe gelingt gemäß den kennzeichnenden Merkmalen des Patentanspruches 1. Weitere vorteilhafte Ausgestaltungen der erfindungsgemäßen Schaltungsanordnung sind den abhängigen Ansprüchen entnehmbar.

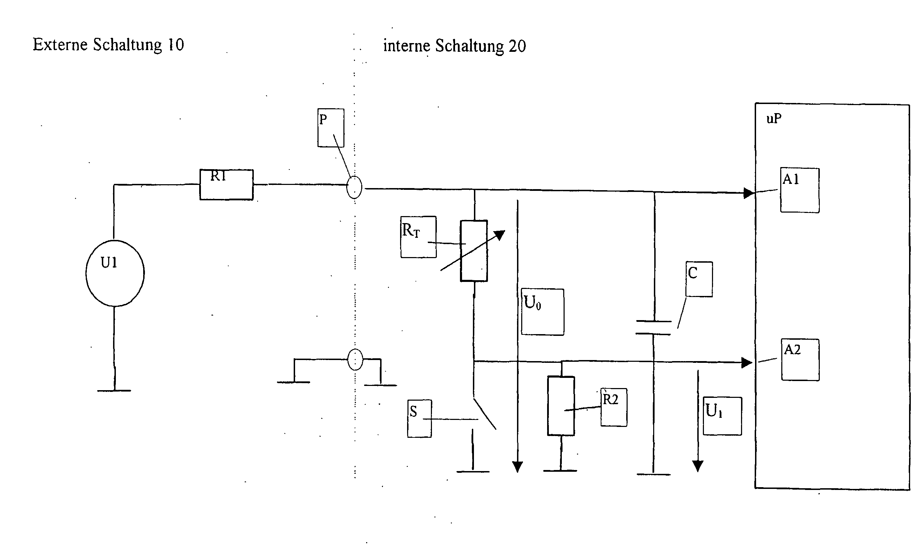

Anhand der einzigen Figur der beiliegenden Zeichnung sei im folgenden die Erfindung näher erläutert.

Eine externe Schaltung 10 z.B. in Form eines bekannten Reglers besitzt eine bekannte Spannungsquelle $U_1$, die über einen bekannten Längswiderstand R1 an den veränderlichen Widerstand $R_T$ einer internen Schaltung 20, z.B. in Form eines Temperaturfühlers angeschlossen ist.

Erfindungsgemäß ist der veränderliche Widerstand $R_T$ über einen Schalter S an ein Referenzpotential, z.B. Masse, angeschlossen. Dem Schalter S ist ein bekannter, durch die Temperatur nicht veränderlicher Widerstand R2 parallelgeschaltet. Ferner ist der Reihenschaltung aus dem veränderlichen Widerstand $R_T$ und der Parallelschaltung aus Schalter S und unveränderlichem Widerstand R2 ein Speicherkondensator C parallelgeschaltet.

Die externe Schaltung 10 kann bei geschlossenem Schalter S über die Spannung an ihrem Ausgang P den Wert des veränderlichen Widerstandes $R_T$ und damit den Temperatur-Istwert feststellen, da ihr die Größe ihrer Betriebsspannung $U_1$ und des Längswiderstandes R1 bekannt sind.

Andererseits ist bei geschlossenem Schalter S der internen Schaltung 20 die Spannung an ihrem Eingang P nicht bekannt, die von dem Typ des angeschlossenen Reglers, d.h. der externen Schaltung 10 abhängt.

Um nun den Wert des veränderlichen Widerstandes $R_T$ und damit von der Temperatur in der internen Schaltung 20 zu ermitteln, wird - wie folgt - vorgegangen: Der Schalter S wird kurzzeitig geöffnet. Hierdurch steigt vorgegeben durch die Zeitkonstante $\tau = R_T \cdot C$ die Spannung im Punkt P an. Gleichzeitig wird während des geöffneten Schalters S an den Ausgängen A1 und A2 die Spannung $U_0$ und die Spannung $U_1$ gemessen. Der Speicherkondensator C sorgt hierbei dafür, daß sich die Spannung im Punkt P nicht sprungartig, sondern nur allmählich ändert. Bei einer kurzzeitigen Öffnung des Schalters S werden daher die Potentialverhältnisse nur unwesentlich verändert.

Aus den gemessenen Spannungen $U_0$ und $U_1$ und dem bekannten unveränderlichen Widerstand R2 kann somit gemäß folgender Beziehung:

$$R_T = \frac{U_0 - U_1}{U_1} \cdot R2$$

der veränderliche Widerstand $R_T$ durch die interne Schaltung ermittelt werden. Dies geschieht vorzugsweise durch einen Mikroprozessor $\mu p$, dem die beiden Spannungen $U_0$ und $U_1$ zugeführt werden und indem der Wert für den bekannten unveränderlichen Widerstand R2 abgespeichert ist.

**Patentansprüche**

1. Schaltungsanordnung zur Messung eines veränderlichen, insbesondere eines in Abhängigkeit von der Temperatur veränderlichen Widerstandes ($R_T$) sowohl durch eine externe (10) als auch eine interne Schaltung (20), wobei der veränderliche Widerstand von der externen Schaltung durch das Anlegen einer bekannten Spannung und eines bekannten Längswiderstandes ermittelt wird, **dadurch gekennzeichnet, daß** innerhalb der internen Schaltung (20) der veränderliche Widerstand ($R_T$) über einen Schalter (S) und einen hierzu parallelgeschalteten bekannten Widerstand (R2) an ein Referenzpotential (Masse) anlegbar ist, daß der Reihenschaltung aus veränderlichem Widerstand ($R_T$) mit der Parallelschaltung aus Schalter (S) und bekanntem Widerstand (R2) ein Speicherkondensator (C) parallelgeschaltet ist und daß der Spannungsabfall ($U_0$) über dem veränderlichen Widerstand ($R_T$) und dem bekannten Widerstand (R2) und der Spannungsabfall ($U_1$) über dem bekannten Widerstand (R2) alleine bei geöffnetem Schalter (S) gemessen wird und der veränderliche Widerstand ($R_T$) durch die interne Schaltung gemäß folgender Beziehung:

$$R_T = \frac{U_0 - U_1}{U_1} \cdot R2$$

ermittelt wird.

2. Schaltungsanordnung nach Anspruch 1, **dadurch gekennzeichnet, daß** der bekannte Widerstand (R2) temperaturkonstant ist.

3. Schaltungsanordnung nach den Ansprüchen 1 und 2, **gekennzeichnet durch** einen Mikroprozessor ($\mu$p), dem die gemessenen Spannungen ($U_0$, $U_1$) zugeführt werden und in dem der Wert des bekannten Widerstandes (R2) abgespeichert ist.

**Claims**

1. Circuit arrangement for measuring a variable resistance ($R_T$), in particular a resistance which varies on the basis of the temperature, both by means of an external circuit (10) and by means of an internal circuit (20), the variable resistance being determined by the external circuit by applying a known voltage and a known series resistance, **characterized in that**, within the internal circuit (20), the variable resistance ($R_T$) can be connected to a reference potential (earth) via a switch (S) and a known resistance (R2) connected in parallel with the latter, **in that** a storage capacitor (C) is connected in parallel with the series circuit comprising the variable resistance ($R_T$) with the parallel circuit comprising the switch (S) and the known resistance (R2), and **in that** the voltage drop ($U_0$) across the variable resistance ($R_T$) and across the known resistance (R2) and the voltage drop ($U_1$) across the known resistance (R2) alone are measured when the switch (S) is open, and the variable resistance ($R_T$) is determined by the internal circuit according to the following relationship:

$$R_T = \frac{U_0 - U_1}{U_1} \cdot R2 \,.$$

2. Circuit arrangement according to Claim 1, **characterized in that** the known resistance (R2) has a constant temperature.

3. Circuit arrangement according to Claims 1 and 2, **characterized by** a microprocessor ($\mu$p) which is supplied with the measured voltages ($U_0$, $U_1$) and stores the value of the known resistance (R2).

**Revendications**

1. Agencement de circuit destiné à mesurer une résistance (21) variable, en particulier d'une résistance variable en fonction de la température, aussi bien par un circuit (10) externe que par un circuit (20) interne, la résistance variable étant déterminée par le circuit externe par l'application d'une tension connue et d'une résistance longitudinale connue, **caractérisé en ce que**, à l'intérieur du circuit (20) interne, la résistance variable ($R_T$) peut être appliquée au moyen d'un interrupteur (S) et d'une résistance (R2) connue, branchée parallèlement à la première, sur un potentiel de référence (masse), **en ce qu'**un condenseur de puissance (C) est branché parallèlement au circuit de série constitué de la résistance variable ($R_T$) avec le circuit parallèle constitué de l'interrupteur (S) et de la résistance connue (R2) et **en ce que** la chute de tension ($U_0$) sur la résistance variable ($R_T$) et la résistance connue (R2) et la chute de tension ($U_1$) sur la résistance connue (R2) sont mesurées uniquement avec l'interrupteur (S) ouvert et la résistance variable ($R_T$) est déterminée par le circuit interne selon la relation suivants :

$$R_T = \frac{U_0 - U_1}{U_1} \cdot R2$$

2. Agencement de circuit selon la revendication 1, **caractérisé en ce que** la résistance connue (R2) est constante au niveau de la température.

3. Agencement de circuit selon les revendications 1 et 2, **caractérisé par** un microprocesseur (pp), auquel les tensions ($U_0$, $U_1$) mesurées sont acheminées et dans lequel la valeur de la résistance connue (R2) est mémorisée.

uP

A1

A2

C

$U_1$

R2

$U_0$

$R_T$

S

P

RT

U1

interne Schaltung 20

Externe Schaltung 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3735900 C